# EUROPEAN PATENT APPLICATION

(11) **EP 3 182 596 A1**
(43) Date of publication of application: **21.06.2017**
(21) Application number: 15201438.7
(22) Date of filing: 18.12.2015
(51) Int. Cl.: H03M 1/74, H03M 1/10

(54) **DIRECT DIGITAL RADIO FREQUENCY MODULATOR WITH CALIBRATION SYSTEM**

(71) Applicant: IMEC VZW, 3001 Leuven (BE)
(72) Inventor: INGELS, Mark Maria Albert, 3001 Leuven (BE); CRANINCKX, Jan, 3001 Leuven (BE)
(74) Representative: DenK iP

(57) **Abstract**

The present invention relates to a direct digital radio frequency modulator comprising
- a plurality of input terminals arranged for being fed with a multi-bit digital signal,
- a plurality of converter circuits (14), each converter circuit arranged for receiving at one of the input terminals one bit of the multi-bit digital signal and for outputting at a converter circuit output terminal an analog output signal (RFOut) in accordance to said one bit, each converter circuit comprising a unit amplifier arranged for amplifying a local oscillator signal and for being switched on and off according to said multi-bit digital signal, said plurality of converter circuits further arranged for combining the analog output signals to form a RF output signal,
- a measurement block (20) comprising mixing means for downconverting the RF output signal and arranged for outputting amplitude and phase information of the downconverted RF output signal
- a processing block (30) arranged for receiving the amplitude and phase information of the downconverted RF output signal, for comparing the amplitude and phase information with a reference amplitude and phase and for deriving a signal to tune at least one parameter of at least one of the converter circuits in accordance with said comparing.

## Description

### Field of the invention

The present invention is generally related to the field of radio devices and more specifically to digital transmitters for a radio device, also called direct digital radio frequency modulators.

### Background of the invention

Radio transmitters are an important part of wireless systems. Thanks to the speed improvement of CMOS technology, analog radio frequency (RF) transmitters can now be integrated in CMOS together with complex baseband processors. However, the parameters of a CMOS transistor which are important for the analog RF design, such as output impedance, supply versus threshold ratio or intrinsic gain typically worsen with the advance of the CMOS technological nodes. Furthermore, modern communication schemes impose tough requirements on radio transmitters. Transmitters operating at RF have to combine hard requirements such as RF bandwidth, linearity and out-of-band noise while maintaining a high efficiency. As a result, the porting of an analog RF transmitter from one technological node to another is complicated and thus slow and costly. Thus, transmitters need to have the least analog circuitry possible. In addition, it is desirable for radio transmitters to be easily scalable with the advancement of CMOS technologies.

To address the problem of analog RF transmitters, a new family of RF transmitters, digital transmitters comprising Direct Digital RF Modulators (DDRM), has been adopted. Sometimes they are also called RF DACs or digital RF modulators. The digital transmitters feature predominantly digital circuitry which is better suited for advanced CMOS technology and which scales much better with the various CMOS technological nodes. In contrast to their analog counterpart, the performance of digital transmitters intrinsically improves with the scaling of CMOS technology.

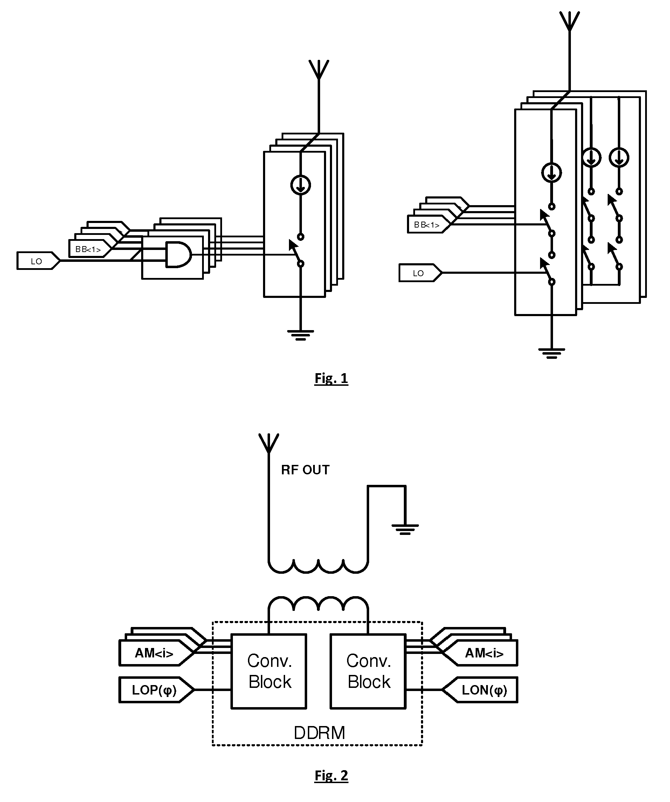

In practical realizations, the DDRM comprises converter circuits containing one or more small unit amplifiers cells typically laid out in a matrix, as shown in Fig.1. The small unit amplifiers typically combine one or a few CMOS switches with one or more active transistors. The converter circuits may have a different weight, which can be obtained by sizing the unit amplifiers or by using multiple unit amplifiers within one converter circuit. The converter circuit outputs are combined to generate an output signal at RF frequency. A DDRM as in Fig.1 comprises an array of converter circuits, that are individually switched on/off at the local oscillator (LO) speed based on a set of modulated LO signals.

The modulated LO signals are created by windowing the original LO signal with baseband data. The windowing can be performed either outside the actual converter circuit (Fig.1 left), but the windowing can also occur inside the circuit (Fig.1 right). The LO signal is typically a square wave with a frequency of up to a few GHz or even tens of GHz, and the baseband data consists of a number of bits, sampled at up to typically a few hundreds of MS/s.

The first digital transmitters were based on a polar architecture, in which a phase-modulated LO is fed to an amplitude DDRM modulator comprising a multitude of converter circuits in which amplitude modulation is performed by enabling or disabling (switching on or off) these converter circuits and then combining their output power to form a modulated RF analog signal. Later, Cartesian DDRM architectures consisting of two such amplitude DDRM modulators, for modulating the in-phase (I) and the quadrature (Q) signals with the respective LO phases, were also adopted in digital transmitters. The outputs of these two digital amplitude modulators are summed before being fed to the antenna for transmission.

To construct a complete digital RF modulator, multiple converter blocks each comprising a set of converter circuits are typically used. Fig.2 shows how in a polar implementation two converter blocks are used for the positive and negative outputs of the DDRM and their outputs are combined in a balun to create a single-ended RF output. The amplitude of the RF signal is thus controlled by the baseband data going into these converter blocks. To also control the phase of the RF signal, the phase of the two LO signals must be phase-modulated before being fed into the converter block.

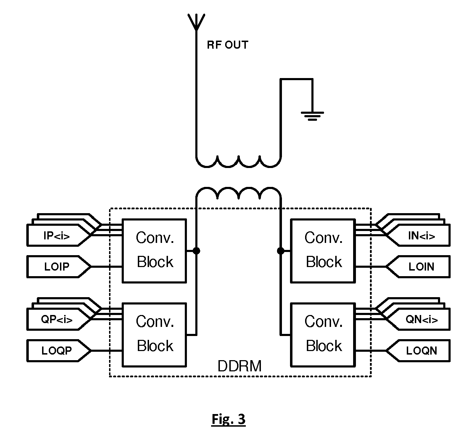

Fig.3 shows a DDRM in a Cartesian implementation, that does not require a separate phase-modulation system for the LO signal, but instead performs Cartesian phase-modulation by combining quadrature LO signals. Four fixed-phase LO signals are used : in-phase (I) and quadrature-phase (Q), positive (P) and negative (N) are fed to four converter blocks, which modulate the amplitude of these respective phases through digital baseband I and Q amplitude data. The outputs of the converter circuits of the various blocks are combined to achieve a full Cartesian upconversion. Also here the positive and negative RF signals are fed through a balun to create a single-ended RF output (RFOut).

The converter circuits in the DDRM need extreme matching accuracy requirements in order to fulfil the very stringent spectral mask specification of many wireless systems. Mismatch in the converter circuits, both in amplitude and phase, limit the maximal possible resolution and thus limit the output signal quality, resulting in a limitation of the in-band signal quality expressed as EVM (error vector magnitude). Even more important is that it also degrades the out-of-band emission, where several undesired (and non-allowed) signal transmissions can occur. These out-of-band signal components actually determine the minimal (effective) number of bits needed in the DDRM, which must be very high in order to limit the quantization noise, as this noise is not filtered by a recombination filter, as is the case in a traditional transmitter with a baseband DAC followed by a low-pass filter before the up-conversion mixer. This requirement for a high number of effective bits in the DDRM thus results in the stringent matching requirements.

As an example, long term evolution (LTE) systems require a transmitter with an out-of-band noise floor of around -160dBc/Hz for SAW-less FDD operation. Even for a very high sampling frequency of e.g. 0.5GS/s, the LSB size must be very small, which leads to an accuracy requirement in the order of 14-bit in the DDRM. Note that this requirement is set for the combination of amplitude and phase. It is practically impossible to achieve the converter circuit matching required by such an effective number of bits by design in a reasonable area at the high DDRM's operation frequency. Hence, a high resolution DDRM must rely heavily on calibration. During a calibration step these converter circuits must be measured with an accuracy of better than one LSB, such that the correct calibration setting can be applied for proper operation. Consequently, it is desirable that all converter circuits being combined to create the DDRM (in which the converter circuits can be binary weighted, thermometer coded or a combination thereof) be tuneable so that their output amplitude and phase can be adjusted to achieve a good matching. Alternatively or additionally, a digital correction could be applied on the baseband signal input to the DDRM, albeit at the expense of processing power consumption and some effective resolution.

Although many transmitters - digital or not - employ some calibration or predistortion, this is typically performed to counter the global non-linear distortion of the transmitter due to compression at higher output power. When considering the quantization noise in a DDRM, the equivalent INL/DNL of the DDRM has to be considered. In this case, there is a clear need for accurately measuring-the output amplitude and phase of the converter units of the DDRM, with a precision better than 1 LSB of the DDRM such that a calibration or correction can be applied afterwards based on said accurate measurements. In practice, however, measuring the converter circuits over the full DDRM range with this accuracy is difficult.

### Summary of the invention

It is an object of embodiments of the present invention to provide for a direct digital radio frequency modulator arranged for allowing a precise measurement of the output amplitude and phase of the constituting converter circuits and for performing a calibration wherein said precise measurements are exploited.

The above objective is accomplished by the solution according to the present invention.

In a first aspect the invention relates to a direct digital radio frequency modulator comprising
- a plurality of input terminals arranged for being fed with a multi-bit digital signal,
- a plurality of converter circuits, each converter circuit arranged for receiving at one of said input terminals one bit of said multi-bit digital signal and for outputting at a converter circuit output terminal an analog output signal in accordance to said one bit, each converter circuit comprising a unit amplifier arranged for amplifying a local oscillator signal and for being switched on and off according to said multi-bit digital signal, said plurality of converter circuits further arranged for combining said analog output signals to form a RF output signal,
- a measurement block comprising mixing means for downconverting said RF output signal and arranged for outputting amplitude and phase information of said downconverted RF output signal
- a processing block arranged for receiving said amplitude and phase information of said downconverted RF output signal, for comparing said amplitude and phase information with a reference amplitude and phase and for deriving a signal to tune at least one parameter of one of said converter circuits in accordance with said comparing.

The proposed solution indeed allows for a precise measurement of the output amplitude and phase. An extra circuit is provided to individually measure the converter circuits. The measurement results are then fed to a processing block adapted for running a calibration algorithm wherein the measured amplitude and phase are compared with a reference amplitude and phase. Next, a signal is determined with which at least one parameter of a converter circuit is tuned.

In a preferred embodiment the processing block comprises memory to store residual information obtained when performing said comparing. Advantageously, the direct digital radio frequency modulator comprises further memory to store the amplitude and phase information of the converter circuits.

In one embodiment one or more of the converter circuits is arranged for being used as reference. Advantageously, the reference amplitude and phase are derived from the one or more of the converter circuits being used as reference.

In one embodiment the reference amplitude and phase are derived from one or more of the converter circuits being used as reference. In one embodiment the amplitude and phase information received in the processing block is derived from one or more of said converter circuits different from said converter circuits being used as reference.

In another embodiment the processing block is arranged for tuning amplitude or phase of at least one converter circuit.

In one embodiment the processing block is arranged for tuning more than one converter circuit, each of said more than one circuit belonging to a converter block having a different LO phase.

In an advantageous embodiment the amplitude and phase information is time varying.

In an embodiment at least one of the converter circuits is arranged for tuning the amplitude and phase of the converter circuit.

In another embodiment the direct digital radio frequency modulator comprises a predistortion block arranged for receiving the signal to tune the at least one parameter of one of the converter circuits and for exploiting that signal to tune the at least one parameter to adapt a predistortion transfer function accordingly.

In one embodiment the direct digital radio frequency modulator comprises buffering means. In an embodiment the buffering means are part of the measurement block.

In another aspect the invention relates to a method for calibrating a converter circuit of a direct digital radio frequency modulator comprising a plurality of converter circuits, each converter circuit arranged for receiving at one of said input terminals one bit of said multi-bit digital signal and for outputting an analog output signal in accordance to said one bit, each converter circuit comprising one or more unit amplifiers arranged for amplifying a local oscillator signal and for being switched on and off according to said multi-bit digital signal, said plurality of converter circuits further arranged for combining said analog output signals to form a RF output signal. The method comprises :
- downconverting said RF output signal and obtaining amplitude and phase information of said downconverted RF output signal,
- comparing said amplitude and phase information with a reference amplitude and phase,
- deriving a signal to tune at least one parameter of one of said converter circuits in accordance with said comparing.

In an advantageous embodiment also an accumulated error of previously calibrated converter circuits is taken into account in the step of deriving a signal.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates converter units, each comprising one or more unit amplifiers, combined in a DDRM.
Fig.2 illustrates a polar digital transmitter.
Fig.3 illustrates a Cartesian digital transmitter.
Fig.4A illustrates an embodiment of the present invention. Fig.4B offers a more detailed view on the measurement block.
Fig.5 illustrates a calibration procedure considering the cumulative residual error of the tuned converter circuits for calibration and comparing this with a calibration based on individual smallest error calibration.
Fig.6 illustrates a calibration procedure applying alternative larger and smaller tuning and comparing this with a calibration based on individual smallest error calibration.
Fig.7 illustrates an embodiment with subtraction of offset signals.
Fig.8 illustrates an embodiment with a mapping block for performing predistortion.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

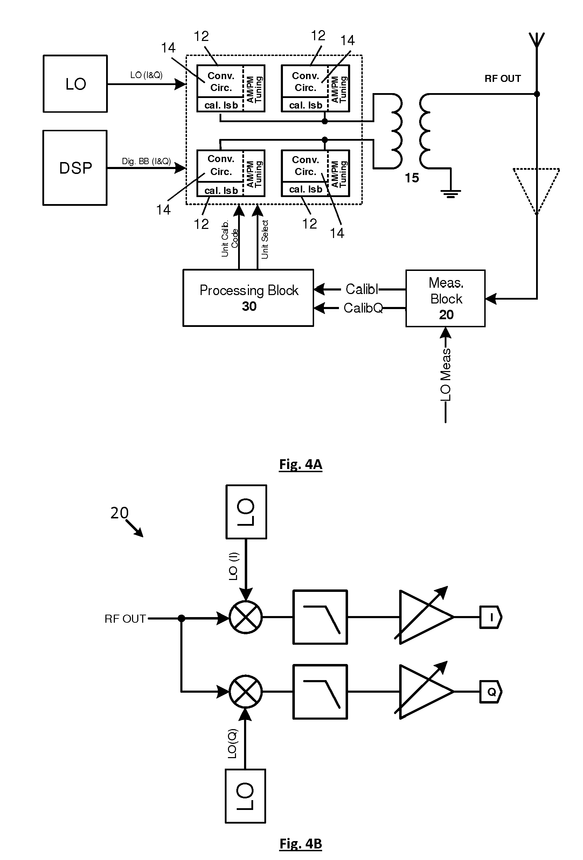

Fig.4A illustrates an embodiment of a set-up according to the present invention. It shows a differential IQ implementation of direct digital RF modulator comprising a plurality of converter circuits (14), grouped in four converter blocks (12) (i.e., positive and negative with each an in-phase and a quadrature component) receiving a particular LO phase. The outputs of the various converter units are combined to form a single RF output signal. This RF output signal (RFOut) is applied to a measurement block (20). A detailed view on an implementation of the latter block is given in Fig.4B. In the measurement block the RF output signal is downconverted to a baseband signal, e.g. with a quadrature downconversion mixer, so that a measurement can be performed of amplitude and phase of the downconverted signal. Note that alternative implementations are possible : the measurement block may, for example, apart from filtering means and amplification means also comprise an A/D converter for digitizing the I and Q component. During calibration, the RF output signal is generated by one or a few converter unit(s) and downconverted to a baseband signal in the measurement block. The proposed approach only compares downconverted baseband signals with approximately the same amplitude and phase. Hence, the measurement does not need absolute nominal accuracy. Instead, an accurate reproducibility is needed, meaning that between two subsequent measurements of the same input the measured value should not change by more than a fraction of an LSB. The processing block (30) receives the information on the amplitude and phase of the downconverted signal and exploits it when running a calibration algorithm. The converter circuits (14) in the direct digital RF modulator are calibrated individually. The calibration comprises a comparing of the measured amplitude and phase with reference amplitude and phase information. This reference information may be obtained in various ways, as discussed more in detail below, and is preferably stored in a memory. This information is exploited by the calibration algorithm which yields a set of optimal tuning parameters to tune the phase and amplitude of the individual converter circuits. These tuning parameters are stored in memory (local in the calibration block (30), in the DDRM or even added in the converter circuit (14)). Note that these parameters are not dependent on the input signal. Further also the information on the amplitude and phase of the downconverted signal of the individual converter circuits may be kept in memory.

To be tunable, each converter circuit has some additional inputs that control its amplitude and phase. One possible realization is described here. However, various implementations are conceivable. In order to tune the amplitude, some additional downsized unit amplifiers (tune amplifiers), with a weight smaller than 1 LSB (e.g. 0.3LSB), may be added to the converter circuit. These tune amplifiers are controlled by the processing block, which determines whether they will be active or not during transmission. They operate fully in parallel with the unit amplifiers of the converter circuits. By having more or less of these tune amplifiers activated, the amplitude of the converter circuit is higher or lower. Note that in this case the nominal output of the converter circuit is typically chosen with half the tune amplifiers active (as it should be possible to deactivate some to reduce the converter circuit amplitude). The weight of the tune amplifiers determines the minimal tuning step (and the achievable accuracy), while the number of tune amplifiers determines the maximal tuning range. Obviously, other methods may be employed to control the amplitude of the converter circuit, such as e.g. tuning the gain of the unit amplifiers. To tune the converter circuit phase, it is possible to adjust the timing of the (modulated) LO for each converter circuit separately, by adding a tunable delay in the (modulated) LO input of each converter circuit. The arrival of the (modulated) LO to each of the converter circuits can be controlled (more or less delayed), which is equivalent to adjusting the phase of these converter circuits.

Contrary to the elements in a traditional DAC calibration system, the converter circuits in a digital transmitter must be calibrated for mismatch in both the amplitude and phase of their output. To enable this, the measurement system is extended with a quadrature downconversion mixer as shown in Fig.4, which has two outputs (e.g. CalibI and CalibQ). During calibration, the converter circuit to be calibrated is activated by means of a fixed code determined by the processing block. The processing block can control any converter circuit individually and can thus overrule the digital baseband signal at the conversion circuit input.

As an example, the processing block can turn on any individual converter circuit in a thermometer code segment of the DDRM independently (while the multi-bit signal from the DSP only controls the sum of converter circuits which corresponds to the transmitted code. A thermometer code is a code wherein from the LSB position on towards the MSB position a number of consecutive 1's occur and wherein the remaining positions up to the most significant bit, if any, are 0's. In a thermometer coded DDRM all converter circuits have the same weight, i.e. contain the same number of unit amplifiers.

As another example, the multi-bit signal at the input of the DDRM turns on the second thermocoded converter circuit together with the first one when transmitting code 2. The processing block (30) can access the second thermocode converter unit independently. The processing block can also access the units of the positive and negative segment of the (differential) DDRM independently (while the multi-bit signal of the DSP typically controls the equivalent converter units of the positive and negative side concurrently). The corresponding amplitude and phase is thus generated by the DDRM. This is also applied to the measurement block. This signal is downconverted in the measurement block to obtain the amplitude and phase information of the signal (CalibI and CalibQ in Fig.4). If the same LO signal for the upconversion is used in the DDRM and for the downconversion in the measurement block, the measurement block output is a DC signal. This can easily be filtered from unwanted higher-frequency components, amplified and next measured accurately. From the measured I and Q values, the amplitude and phase of the measured unit can easily be derived. If in the measurement block an LO signal is used with a frequency offset with respect to the LO signal applied to the DDRM, the downconverted signal is a low frequency signal, from which amplitude and phase can be derived as well.

To shield the measurement block from the RF output, an RF buffer with high input impedance may be provided at the input of the measurement block. In its most simple form, the buffer can just be a high-valued resistor (e.g. a few kΩ). As all signals applied to the measurement block are chosen in the same range when applying the calibration algorithm, linearity of the buffer and measurement block is not important.

A key feature of the proposed calibration process is that only relative measurements are performed. For example, in a thermometer-coded DDRM, one converter unit provided with one or more unit amplifiers is used as 'reference'. All other converter circuits having in total the same weight as the reference converter circuit, e.g. with the same number of unit amplifiers are activated sequentially and measured one-by-one and calibrated until their output is ideally exactly the same as the chosen reference. After calibration, the DDRM is on target, both in amplitude and phase. In other words, the distance between the complex response (I and Q) of the DDRM and the ideal complex response (I/Q) is smaller than 0.5 LSB step. As the calibration accuracy depends on the accuracy of the tuning, the tuning step and range must be so chosen to be able to achieve this. In practice, the various converter circuits do not have exactly the same output, even after calibration, but one close to the chosen reference, depending on the calibration step accuracy, chosen such that the resulting integral non-linearity (INL) and differential non-linearity (DNL) of the DDRM are within specification (typically less than 1 LSB).

In DDRMs which are not thermometer coded, a combination of multiple converter circuits can be used as a reference. An example is given below :
- Suppose as an example that the 5 MSB bits of a 10-bit DDRM are thermometer-coded and contain 31 weighted (weight 32) converter circuits, while the 5 LSB converter circuits are binary-coded.
- The reference signal is chosen to be the sum of those 5 LSB converter circuits (having a cumulative weight of 1+2+4+8+16=31) plus one extra LSB converter circuit. This extra LSB converter circuit is provided in the converter block (cal. Lsb in Fig.4). The extra LSB is not required in the case of a purely thermometer coded DDRM, as in this case all converter circuits have the same weight. It is only useful for a segmented or binary implementation. Note that segmented may also be for two (or more) thermometer coded segments (as the segments will have converter circuits of a different weight). The additional LSB converter circuit is equal to the DDRM's LSB (Least significant bit) converter circuit. So all the MSB converter circuits are turned off and the 5 LSB converter circuits plus the extra cal. LSB are turned on and the analog output, which is the sum of the active converter circuits, is measured and used as a reference value.
- Next all converter cells are turned off, except the first MSB converter circuits (which nominally has an output weight of 32) is activated. If a different output is measured, the converter cell is calibrated until its output is as close as possible to the reference value.
- The same is done for all the other (#2 to #31) MSB cells.

In one embodiment the calibration algorithm as proposed is applied while taking into account both the CalibI and CalibQ (see Fig.4) values when comparing the output of an MSB cell with the reference output of all LSBs + 1. When adjusting the amplitude and phase of the MSB cells, the setting can be chosen which either gives a (CalibI, CalibQ) value closest to the reference value or gives the smallest accumulated error for all previous MSBs plus this one.

In a preferred embodiment the amplitude and phase of the converter circuit being calibrated is not simply tuned to the amplitude and phase closest to the reference given the minimal tuning step. Instead, the accumulated error for all previous calibrated converter circuits plus the one being calibrated is being considered to determine the optimal tuning. In this way, for a given minimal available tuning step, the INL is reduced.

In one embodiment a balun (15) is used to derive the RF output signal resulting from the outputs of various converter circuits with opposite LO phases. To limit the required dynamic range of the measurement, an unused converter circuit of the set of converter units on the opposite side of the balun can be used to generate a subtraction signal in phase with the output of the converter circuit being calibrated (or being used as a reference), such that due to the inherent common-mode suppression of the balun, only a small RF output signal is generated. An amplifier in the measurement block may be used to sufficiently amplify the small RF output signal so that small variations can be measured needed for accurate calibration.

In a differential embodiment a set of unused converter circuits may be used to create an offset in the measurements. It is advantageous to perform measurement on a signal with reduced amplitude. Having a small signal to be measured during calibration has two main advantages. A measurement with a required absolute accuracy is easier on a relatively small signal (as the ratio between the measured signal and that accuracy is important). Further, in the given case only a small signal is present at the transmitter output during calibration, so the transmitter does not need to be disconnected from the antenna. This can be achieved by subtracting the signal of one or a few converter circuits from the signal being measured. For this a third set of converter circuits is switched on during the same calibration. In case of a differential implementation this third set can be selected among converter circuits on the opposite side of the balun from the converter circuits being calibrated. When the LO provided to both the measured set and the third set of converter circuits has the same phase, the subtraction of their outputs occurs in the balun.

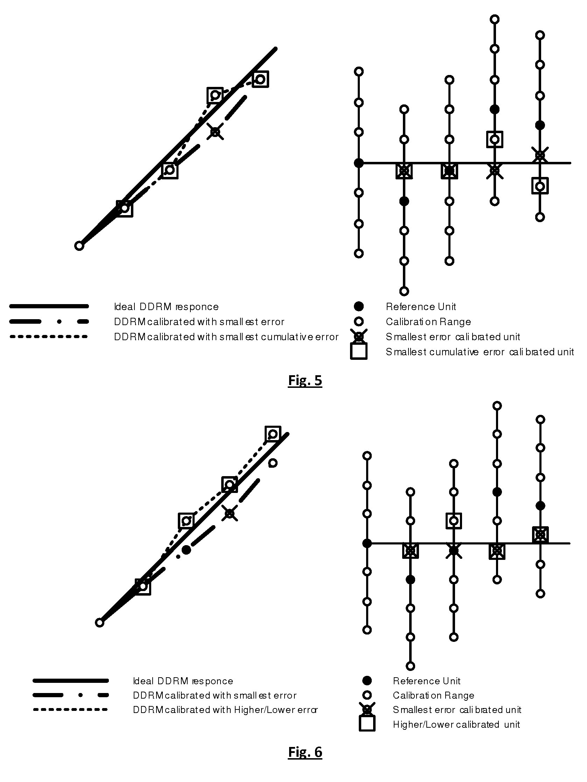

Typically the calibration on the calibrated converter circuits does not reach the ideal value and, hence, a calibration to the value just below or just above the ideal result must be carried out. This, one approach is to choose the value (above or below) that is closest to the ideal result. This is shown in Fig.5 and Fig.6, where it is compared to other approaches. An alternative is to take the accumulated (known) remaining errors of the previously calibrated converter circuits into account, e.g. by choosing a calibration setting for this converter circuit such that the accumulated error of all previous and this converter circuit is closest to zero, see Fig.5. Both approaches allow limiting the overall DDRM non-linearity (both in amplitude and phase). Obviously, DNL has still to be considered as well. This calibration sequence typically results in a better INL for a given accuracy of the tunability of the converter circuits, or requires less tunability of the converter circuits for a given INL requirement.

Another alternative calibration sequence is to tune the subsequent converter circuits being calibrated alternatively just above and just below the reference. This scheme has a lower complexity, as it does not need to keep track of the cumulative error and therefore does not need to measure this error as accurately. Instead, it only needs to compare the difference of the output of the calibrated converter circuit with the reference, and make sure it has an opposite sign to the difference of the previously calibrated converter circuit. This is demonstrated in Fig.6.

The main features of the proposed calibration algorithm are now described. A DDRM comprises multiple converter circuits (14), which are typically be grouped in converter blocks (12). As an example, a differential Cartesian DDRM is considered comprising four converter blocks : one for positive I, one for positive Q, one for negative I and one for negative Q. Other DDRM architectures may contain two converter blocks (polar differential or single-ended Cartesian) or even only a single one (single-ended polar). Various implementations of a suitable calibration algorithm are available for each of these examples. The converter blocks may be thermometer coded, binary coded or a combination of both (segmented coded). The calibration is described for a thermometer coded RF-DAC, but it can readily be extended to binary or segmented code.

In the thermo-coded converter block, a first converter circuit is considered as the reference. It is used with a static code for transmission in the DDRM. The DDRM upconversion operation results in an RF signal at the LO frequency, with a certain amplitude and phase with respect to the transmitters LO. These amplitude and phase are measured and considered as a reference for all the thermo-coded converter circuits with the same weight. This first reference converter circuit is then turned off and a second converter circuit is measured in the same way, yielding another amplitude and phase. Based on these measurements, the second converter circuit is calibrated by controlling the amplitude and phase of this converter circuit output. The accuracy with which this is possible, is determined by the minimal calibration step (which also determines the minimal achievable DNL). The calibrated converter circuit has a certain error with respect to the reference converter circuit. It may be too small or too large (again, both for amplitude and phase, each of which can be considered independently). The error of the calibrated converter circuit is measured with a higher accuracy than the calibration step and stored in memory. The second converter circuit is disconnected and a third converter circuit is measured. Now, for the calibration, the memorized error is considered. The converter circuit is calibrated, not to minimize the error with respect to the reference, but to minimize the sum of the memorized error and the remaining error after calibration. This sum is then stored in memory for use when the next converter circuit is calibrated. All converter circuits are calibrated subsequently in this way. The result is shown in Fig.6, where the fourth converter circuit is not calibrated for minimal error with the reference, but for minimal summed error. In this way, the INL is improved while not degrading the DNL beyond spec. In a DDRM consisting of multiple converter blocks, the elements of another converter block can be tuned with respect to the first reference unit discussed above, or based on a local reference.

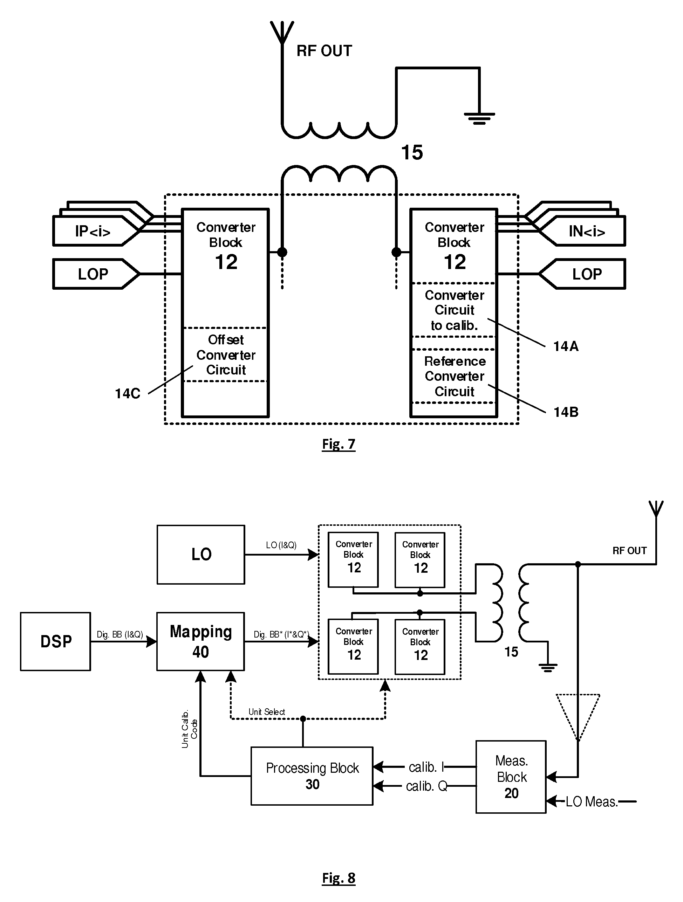

As an alternative, a simplified scheme for a differential implementation is possible which does not require an accurate measurement of the remaining error of the calibrated converter circuit (14A) with respect to the reference (14B). In this simplified scheme the subsequent converter circuits are calibrated alternatively to be just above or just below the reference. This is illustrated in Fig.7.

In a segmented DDRM implementation the various segments have to be calibrated with respect of each other to maintain the linearity of the DDRM over its full range. The proposed calibration scheme can be extended to this architecture when an extra LSB converter circuit is implemented. A converter circuit of a segment with a given weight is then calibrated with respect to a reference, which is obtained by turning on all lower weighted converter circuits plus the extra LSB converter circuit. As an example, in a 10 bit, 5bit binary/5 bit thermo (5B/5T) DDRM, the sum of all binary converter circuits +one extra LSB converter circuit (16+8+4+2+1 +1) are used as a reference for the thermo converter circuits (32). Similarly, in a binary coded section, a bit with a given weight can be tuned against the sum of all the underlying bits + one extra LSB.

To further ease the calibration system requirements, when calibrating a converter block, a third set of converter circuits (14C) of the now unused converter block connected to the opposite sign input of the balun (15) is used to generate an offset RF signal subtracted from the signal that is generated by the converter circuit (14A) in the converter block under calibration (Fig.7). For example, when calibrating the positive in-phase MSB converter circuit in a 5B/5T coded converter block (IP), this generates output RF signals that nominally have a phase around 0° and an amplitude around 32 LSBs (in the given 5B/5T example). The IN converter block, which is normally used to generated RF signals with a phase of 180°, is now driven by the LOIP signal instead of the LOIN signal, such that it also outputs RF signals with 0° phase. Its data input is also set to a value smaller than or equal to 32, such that the balun is now driven by two in-phase signals, which results in a smaller RF signal at the RF output. This smaller signal is easier to measure with a given absolute accuracy (as measurement accuracy is typically relative with the measured signal). Furthermore, as the signal on the RF output is smaller during calibration, the antenna may not have to be decoupled from the transmitter during calibration to avoid transmitting unwanted spurs if that signal is small enough. In this calibration sequence, the converter circuits with subtracted signal from the said third set are calibrated using the reference converter circuit's signal subtracted signal from the third set's.

A special case occurs when the signal of the third set has the same nominal value as the converter circuits to be calibrated. In this case, the third set can be used as a reference. When the value of the third set and the converter units to be measured are nominally the same, in reality they are of course slightly different due to mismatches. Both signals are applied to the inputs of the balun, which subtracts them from each other. If both signals are identical, the subtraction by the balun is perfect and no signal is present at the output of the balun. If there is some error between both sides, this error is a differential signal which goes through the balun and is found at its output. In other words, an ideal balun only conveys the error between both sides. In practice, the balun has a limited common-mode rejection and a (small) part of the common mode goes through. This is added to possible LO feedthrough. It results in an RF signal of some phase and amplitude at the output that can be measured by the measurement block. This amplitude is significantly smaller than the converter circuit outputs (due to the common mode rejection), such that it can easily be measured with a higher accuracy than when being measured on the original signal, as measurement accuracy is relative to the measured signal (one measures with a certain percentage accuracy) and as the measurement requirements in this scheme are absolute (sub-LSB requirement).

This approach has two significant advantages. First, during calibration, only the error signal is transmitted. As this is very small, the transmitter does not need to be decoupled from the antenna during calibration to avoid transmitting unwanted spurs. Secondly, the error is measured directly and not together with a big signal. This allows for an easier measurement (e.g. to measure an error of 0.1 LSB on a 512 weighted thermo-coded unit, an accuracy of 0.02% is needed, whereas with the proposed scheme the signal to be measured is considerably smaller).

In an alternative embodiment of the calibration system an LO signal of a slightly different frequency from the DDRM's LO is used for downconversion in the measurement block. In that case the measurement block outputs are not DC signals, but sine waves of a small frequency (given by the difference of the two LO frequencies). This allows making a distinction between the various spectral components at harmonics of the LO frequency.

The proposed method of measuring and calibrating can also be used in case there is no direct control possible of the amplitude and/or phase of the converter circuits, e.g. when the DDRM itself cannot be calibrated. In that case the information obtained by measuring the output signal of all converter circuits can be used to digitally predistort the digital transmitter. To realize this predistortion a mapping block (40) is added to the system, that takes as input the digital I and Q modulation data and maps this on the proper digital DI* and DQ* data to be fed into the DDRM based on the inputs given by the processing block, such that the desired RF signal comes out (Fig.8).

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Direct digital radio frequency modulator comprising
- a plurality of input terminals arranged for being fed with a multi-bit digital signal (),
- a plurality of converter circuits (14), each converter circuit arranged for receiving at one of said input terminals one bit of said multi-bit digital signal and for outputting at a converter circuit output terminal an analog output signal (RFOut) in accordance to said one bit, each converter circuit comprising one or more unit amplifiers arranged for amplifying a local oscillator signal and for being switched on and off according to said multi-bit digital signal, said plurality of converter circuits further arranged for combining said analog output signals to form a RF output signal,
- a measurement block (20) comprising mixing means for downconverting said RF output signal and arranged for outputting amplitude and phase information of said downconverted RF output signal,
- a processing block (30) arranged for receiving said amplitude and phase information of said downconverted RF output signal, for comparing said amplitude and phase information with a reference amplitude and phase and for deriving a signal to tune at least one parameter of at least one of said converter circuits (14) in accordance with said comparing.

2. Direct digital radio frequency modulator as in claim 1, wherein said processing block comprises memory to store residual information obtained when performing said comparing.

3. Direct digital radio frequency modulator as in claims 1 or 2, comprising further memory to store said amplitude and phase information.

4. Direct digital radio frequency modulator as in any of claims 1 to 3, wherein said processing block is arranged for selecting one or more of said converter circuits to be used as reference during calibration.

5. Direct digital radio frequency modulator as in claim 4, wherein said reference amplitude and phase are derived from said one or more of said converter circuits being used as reference.

6. Direct digital radio frequency modulator as in claims 4 or 5, wherein said received amplitude and phase information is derived from one or more of said converter circuits different from said converter circuits being used as reference.

7. Direct digital radio frequency modulator as in any of the previous claims, wherein said processing block is arranged for tuning amplitude or phase of at least one converter circuit.

8. Direct digital radio frequency modulator as in any of the previous claims, wherein a subset of said converter circuits is arranged to be used as an offset during calibration.

9. Direct digital radio frequency modulator as in any of the previous claims, wherein at least one of said converter circuits is arranged for tuning the amplitude and phase of said converter circuit.

10. Direct digital radio frequency modulator as in any of the previous claims, wherein said amplitude and phase information is time varying.

11. Direct digital radio frequency modulator as in any of the previous claims, comprising a mapping block (40) arranged for receiving said signal to tune said at least one parameter of one of said converter circuits and for exploiting said signal to tune said at least one parameter to adapt a predistortion transfer function accordingly.

12. Direct digital radio frequency modulator as in any of the previous claims, comprising buffering means.

13. Direct digital radio frequency modulator as in claim 11, wherein said buffering means are part of said measurement block.

14. Method for calibrating a converter circuit of a direct digital radio frequency modulator comprising a plurality of converter circuits (14),each converter circuit arranged for receiving at one of said input terminals one bit of said multi-bit digital signal and for outputting an analog output signal (RFOut) in accordance to said one bit, each converter circuit comprising a unit amplifier arranged for amplifying a local oscillator signal and for being switched on and off according to said multi-bit digital signal, said plurality of converter circuits further arranged for combining said analog output signals to form a RF output signal, the method comprising :
- downconverting said RF output signal and obtaining amplitude and phase information of said downconverted RF output signal,
- comparing said amplitude and phase information with a reference amplitude and phase,
- deriving a signal to tune at least one parameter of one of said converter circuits in accordance with said comparing.

15. Method for calibrating as in claim 14, wherein in said step of deriving a signal also an accumulated error of previously calibrated converter circuits is taken into account.
